# EUROPEAN PATENT SPECIFICATION

(11) **EP 0 516 714 B1**
(45) Date of publication and mention of the grant of the patent: **18.10.1995**
(21) Application number: 91905109.4
(22) Date of filing: 15.02.1991
(51) Int. Cl.: C23C 16/34, C23C 16/40, C23C 16/54, C23C 16/46, C03C 17/00, C23C 16/44

(54) **TITANIUM NITRIDE OR TIN OXIDE BONDING TO A COATER SURFACE**
TITANNITRID- ODER ZINNOXIDAUFLAGE AUF DER OBERFLÄCHE EINER BESCHICHTUNGSANLAGE
ACCROCHAGE DE NITRURE DE TITANE OU D'OXYDE STANNIQUE A LA SURFACE D'UNE MACHINE A ENDUIRE

(30) Priority: 22.02.1990 US 485267
(43) Date of publication of application: 09.12.1992
(73) Proprietor: GORDON, Roy Gerald, Cambridge, MA 02138 (US)
(72) Inventor: GORDON, Roy Gerald, Cambridge, MA 02138 (US)
(74) Representative: Bankes, Stephen Charles Digby
(86) International application number: US9101190
(87) International publication number: WO9113184

(56) References cited:
- JP-A-59 125 615
- US-A- 4 535 000
- US-A- 4 585 674
- US-A- 4 895 734
- PATENT ABSTRACTS OF JAPAN, vol. 13, no. 246 (E-769), 8 June 1989; & JP-A-10 47 019

## Description

Glass and other transparent materials can be coated with transparent semi-conductor films such as tin oxide in order to reflect infra-red radiation. Such materials are useful in providing windows with enhanced insulating value (lower heat transport) for use in architectural windows, etc.; see for example, US Reissue Patent 31,708. The coating of glass with a titanium nitride coating for a solar control purposes is also known, see U.S. Patent 4,535,000. A glass coated first with titanium nitride and subsequently with tin oxide is disclosed in U.S. Patent 4,690,871. Coatings on glass of either tin oxide or titanium nitride or both, and also in combination with other coatings such as iridescence - suppression coatings are now enjoying commercial acceptance.

When a glass surface is to be coated first with titanium nitride and then overcoated with tin oxide, these coatings are applied in sequence. That is, a first coater will deposit the titanium nitride and subsequently a second coater will deposit the tin oxide. Ideally, it would be desirable to control the fluid flow characteristics of the reactants which form the titanium nitride and tin oxide and the spatial relationship between the coater surfaces overlying the moving glass surface, such that the titanium nitride and tin oxide which are formed, would only deposit on the moving glass surface. As a practical matter this has not been possible to achieve with the result that titanium nitride will build up or coat the coater surface overlying the glass surface on which the titanium nitride is deposited by reaction of titanium tetrachloride and ammonia. Similarly, the tin oxide coats the coater surface overlying the glass surface on which the tin oxide is deposited by reaction of tin tetrachloride and water vapor. The build-up of these coatings on the surfaces of the coaters is uneven and sometimes tends to peel or flake away from the coater surface during a production run. The peeling or flakes which remain attached to the surface disturb the reactant gas flow patterns and cause bands or other irregularities in the coating on the glass.

JP-A-59-125615 discloses a parallel plate-type plasma chemical vapour deposition apparatus for the manufacture of semiconductor devices. In order to prevent dust or other particles from falling from an upper electrode onto a lower surface on which a film was being formed, the surface of the upper electrode is sandblasted to render it irregular.

The present invention consists in a method of coating a surface of a moving sheet substrate of glass or other transparent material, wherein said substrate is passed through at least one coater and a coating is formed on an upper surface of the substrate by chemical vapour deposition of a compound formed from reactant gases as it passes below a bottom surface of a section of the coater which is also in contact with said reactant gases, and which accordingly has some of said compound deposited thereon, characterised in that in order to prevent peeling of said compound therefrom said bottom surface is roughened to a root mean square distance of the surface from its average height of at least 0.1 mm, increasing the surface area by at least 20%.

It is possible by means of this invention to prevent deposits of for example titanium nitride or tin oxide from peeling or flaking from the coater surfaces.

According to a further aspect of the invention there is provided apparatus for coating a moving sheet substrate of glass or other transparent material by chemical vapour deposition, comprising at least one coater means for passing said substrate through the coater and means for supplying reactant gases to a gap between the substrate and a section of the coater, characterised in that said section of the coater has a lower surface, overlying the substrate, which is roughened to a root mean square distance of the surface from its average height of at least 0.1 mm. The roughened surface provides an increased surface area for an interlocking or keyed fit between the coating and the coater surface thereby strengthening the adhesive bond between the coating and the surface. The roughening can be carried out by sand blasting, filing, machining with a knurling tool or other methods that will be clear to those skilled in the art. Subsequent to the roughening of the surface, the surface is preferably cleaned to remove the remaining loose particulates from the surface for example by blowing with compressed air.

A preferred embodiment of the invention will now be described with reference to the accompanying drawings wherein:
Figure 1 is a cross section side elevation of a coater used for depositing titanium nitride on a glass surface followed by an overcoating of tin oxide; and
Figure 2 is a cross section view of a roughened surface.

The invention will be described with reference to roughening coater surfaces of coaters which are used for the sequential deposition of titanium nitride and tin oxide on a moving glass surface. The coatings can be deposited using, for example, the reactant systems known in the art, i.e., those described in U.S. Patent No. 4,535,000 for titanium nitride and U.S. Patent No. 4,585,674 for tin oxide. In a production run, a coating of about 40 nm of titanium nitride can be followed by a coating of 30 nm of fluorine-doped tin oxide.

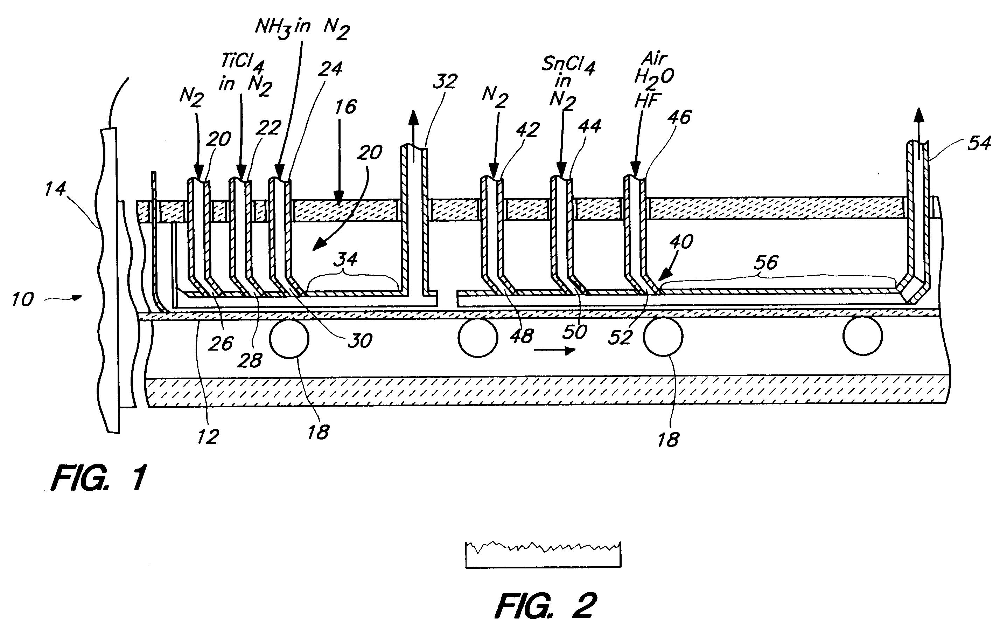

Referring to Figure 1, an exemplary coater is shown generally at 10 installed between a float tank 14 and an annealing lehr (not shown). Alternatively, one or both of the coaters may be positioned in the float tank, in which the glass floats on liquid tin. A glass sheet 12 exits from the float tank 14 and travels through a horizontal galley 16 while supported on rollers 18. Adjacent the exit end of the float tank is a first coating apparatus 20. Nitrogen; titanium tetrachloride and nitrogen; and ammonia and nitrogen are introduced into feed conduits 20, 22 and 24 and are discharged through transverse slots 26, 28 and 30. Downstream of the conduit 24 is an exhaust conduit 32. The surface of the underside of the coater section 34 is primarily affected by the build up of titanium nitride.

A coater 40 similar to the coater 20 has three feed conduits 42, 44 and 46 into which gaseous reactants nitrogen; stannic chloride and nitrogen; and air, water vapor and hydrogen fluoride respectively are introduced. The gases are discharged through transverse slots 48, 50 and 52 respectively. At the downstream end of the coater 40 there is a discharge conduit 54. The surface of the underside of the coater section 56 is primarily affected by the build up of tin oxide.

When the coaters start coating the glass, the surfaces of the sections 34 and 56 of the coaters 20 and 40 commence to build up layers of titanium nitride and tin oxide respectively. For a conventional smooth coater surface, when the titanium nitride reaches an average thickness of about 0.2 to 1 mm, then peeling, flaking and unevenness commences to develop causing irregularities in the coating deposited on the moving glass surface.

When the tin oxide reaches an average thickness of between 0.5 to 2 mm on a smooth coater, then peeling, flaking and unevenness commences to develop causing irregularities in the coating deposited on the moving glass surface.

For a typical production run with smooth coaters producing titanium nitride followed by an overcoating of tin oxide with the glass moving at 7.62 m (300 inches) per minute, the run or coating operation can continue generally for about an hour before the peeling is severe enough to affect the quality of the coating.

To enhance the adhesion of the coatings to the coater surfaces, such as metal or graphite surfaces, they are roughened such as by sand blasting with a sand blaster that is typically used to remove paint from metal and wood surfaces, until the coater has a uniform matte appearance. Subsequently the surface is blown clean with compressed air. It is then found that the length of the production runs can be increased to several hours.

The term "roughened" or "roughness" as used in this disclosure means treating the surface of the coater such that at least twenty (20%) percent more surface area is available for bonding after roughening than before. The surface may be roughened in a uniform or non-uniform pattern. Preferably, the surface after roughening has a textured, grain-like, matte appearance. Alternatively, cuts can be formed defining recesses and projections, grooves forming islands can be cut into the surface, the islands being linear or non-linear, a knurled surface can be created, etc. A roughened surface is shown in Figure 2. The size of the roughness, defined as the square root of the mean square distance of the surface from its average height, is at least 0.1 mm and typically up to 0.5 mm.

## Claims

1. A method of coating a surface of a moving sheet substrate (12) of glass or other transparent material, wherein said substrate is passed through at least one coater (20, 40) and a coating is formed on an upper surface of the substrate by chemical vapour deposition of a compound formed from reactant gases as it passes below a bottom surface of a section (34, 56) of the coater which is also in contact with said reactant gases, and which accordingly has some of said compound deposited thereon, characterised in that in order to prevent peeling of said compound therefrom said bottom surface is roughened to a root mean square distance of the surface from its average height of at least 0.1 mm, increasing the surface area by at least 20%.

2. A method according to claim 1 wherein the compound is titanium nitride.

3. A method according to claim 1 wherein the compound is tin oxide.

4. A method according to any preceding claim wherein the roughened surface is graphite.

5. A method according to any preceding claim which includes the step of removing particulate matter from the surface after roughening.

6. A method according to any preceding claim wherein the surface is roughened by sandblasting.

7. A method according to any one of claims 1 to 5 wherein the surface is roughened by machining the surface.

8. A method according to any preceding claim wherein the roughened surface has a coarse, non-uniform, grain-like appearance.

9. A method according to any one of claims 1 to 7 wherein the surface has a uniform, matte-like surface.

10. Apparatus (10) for coating a moving sheet substrate (12) of glass or other transparent material by chemical vapour deposition, comprising at least one coater (20, 40), means (18) for passing said substrate through the coater and means (20, 22, 24, 42, 44, 46) for supplying reactant gases to a gap between the substrate and a section (34, 56) of the coater, characterised in that said section (34, 56) of the coater has a lower surface, overlying the substrate, which is roughened to a root mean square distance of the surface from its average height of at least 0.1 mm.

11. Apparatus according to claim 10 wherein the roughened surface has a coarse, non-uniform, grain-like appearance.

12. Apparatus according to claim 10 wherein the surface has a uniform, matte-like appearance.

## Patentansprüche

1. Verfahren zum Beschichten der Oberfläche eines plattenförmigen, beweglichen Substrates (12) aus Glas oder einem anderen transparenten Material, gemäß dem das genannte Substrat durch mindestens eine Beschichtungsanlage (20, 40) geführt und mittels chemischer Bedampfung eine Schicht aus einer Verbindung aus Reaktantgasen auf einer oberen Fläche des Substrates gebildet wird, während es unter einer unteren Fläche eines Abschnitts (34, 56) der Beschichtungsanlage hindurchgeführt wird, die ebenfalls in Kontakt mit den genannten reagierenden Gasen steht und auf der sich dementsprechend ein Teil der genannten Verbindung ablagert, dadurch gekennzeichnet, daß die genannte untere Fläche zum Vermeiden eines Abblätterns der genannten Verbindung davon auf einen quadratischen Oberflächen-Rauchtiefenmittelwert von durchschnittlicher Tiefe von mindestens 0,1 mm aufgerauht wird, wodurch die Fläche um mindestens 20% vergrößert wird.

2. Verfahren nach Anspruch 1, gemäß dem die Verbindung Titannitrid ist.

3. Verfahren nach Anspruch 1, gemäß dem die Verbindung Zinnoxid ist.

4. Verfahren nach einem der vorangehenden Ansprüche, gemäß dem die aufgerauhte Fläche Graphit ist.

5. Verfahren nach einem der vorangehenden Ansprüche, das das Entfernen von Feststoffen von der Fläche nach dem Aufrauhen umfaßt.

6. Verfahren nach einem der vorangehenden Ansprüche, gemäß dem die Fläche durch Sandstrahlen aufgerauht wird.

7. Verfahren nach einem der Ansprüche 1 bis 5, gemäß dem die Fläche durch spanabhebende Verfahren aufgerauht wird.

8. Verfahren nach einem der vorangehenden Ansprüche, gemäß dem die aufgerauhte Fläche ein grobes, unregelmäßiges, körniges Erscheinungsbild hat.

9. Verfahren nach einem der Ansprüche 1 bis 7, gemäß dem die Fläche regelmäßig und matt ist.

10. Vorrichtung (10) zum Beschichten eines beweglichen, plattenförmigen Substrates (12) aus Glas oder einem anderen transparenten Material durch chemische Bedampfung, umfassend mindestens eine Beschichtungsanlage (20, 40), Mittel (18) zum Hindurchführen des genannten Substrates durch die Beschichtungsanlage und Mittel (20, 22, 24, 42, 44, 46) zur Abgabe von Reaktantgasen in einen Zwischenraum zwischen dem Substrat und einem Abschnitt (34, 56) der Beschichtungsanlage, dadurch gekennzeichnet, daß der genannte Abschnitt (34, 56) der Beschichtungsanlage eine untere, über dem Substrat liegende Fläche hat, die auf den quadratischen Oberflächen-Rauhtiefenmittelwert von durchschnittlicher Tiefe von mindestens 0,1 mm aufgerauht ist.

11. Vorrichtung nach Anspruch 10, in der die aufgerauhte Fläche ein grobes, unregelmäßiges, körniges Erscheinungsbild hat.

12. Vorrichtung nach Anspruch 10, in der die Fläche regelmäßig und matt ist.

## Revendications

1. Procédé d'enduction d'une surface d'un substrat (12) en feuille, en mouvement, de verre ou autre matière transparente, suivant lequel on fait passer ledit substrat à travers au moins une machine à enduire (20, 40) et un revêtement est formé sur une surface supérieure du substrat par dépôt en phase gazeuse par procédé chimique d'un composé formé à partir de gaz réactifs au fur à mesure qu'il passe sous une surface inférieure d'une section (34, 56) de la machine à enduire qui est également en contact avec lesdits gaz réactifs, et qui, en conséquence, présente un peu dudit composé déposé sur elle, caractérisé par le fait que, pour empêcher un décollement dudit composé à partir de celle-ci, ladite surface inférieure est rendue rugueuse sur une distance moyenne quadratique à partir de sa hauteur moyenne d'au moins 0,1 mm, augmentant l'aire de surface d'au moins 20%.

2. Procédé selon la revendication 1, dans lequel le composé est le nitrure de titane.

3. Procédé selon la revendication 1, dans lequel le composé est l'oxyde d'étain.

4. Procédé selon l'une quelconque des revendications précédentes, dans lequel la surface rendue rugueuse est du graphite.

5. Procédé selon l'une quelconque des revendications précédentes, qui comprend l'étape d'élimination de la matière particulaire à partir de la surface après qu'elle ait été rendue rugueuse.

6. Procédé selon l'une quelconque des revendications précédentes, dans lequel la surface est rendue rugueuse par décapage au jet de sable.

7. Procédé selon l'une quelconque des revendications 1 à 5, dans lequel la surface est rendue rugueuse par usinage de la surface.

8. Procédé selon l'une quelconque des revendications précédentes, dans lequel la surface rendue rugueuse présente un aspect grossier, non uniforme, de type grainé.

9. Procédé selon l'une quelconque des revendications 1 à 7, dans lequel la surface a une surface uniforme, de type mat.

10. Appareil (10) pour enduire un substrat (12) en feuille, en mouvement, de verre ou autre matière transparente, par dépôt en phase gazeuse par procédé chimique, comprenant au moins une machine à enduire (20, 40), des moyens (18) pour faire passer ledit substrat à travers la machine à enduire et des moyens (20, 22, 24, 42, 44, 46) pour amener des gaz réactifs dans un espace entre le substrat et une section (34, 56) de la machine à enduire, caractérisé par le fait que ladite section (34, 56) de la machine à enduire a une surface inférieure, surplombant le substrat, qui est rendue rugueuse sur une distance moyenne quadratique de la surface à partir de sa hauteur moyenne d'au moins 0,1 mm.

11. Appareil selon la revendication 10, dans lequel la surface rendue rugueuse a un aspect grossier, non uniforme, de type grainé.

12. Appareil selon la revendication 10, dans lequel la surface a un aspect uniforme, de type mat.
